# EUROPÄISCHE PATENTSCHRIFT

(11) **EP 2 622 113 B1**
(45) Veröffentlichungstag und Bekanntmachung des Hinweises auf die Patenterteilung: **31.10.2018**
(21) Anmeldenummer: 11775924.1
(22) Anmeldetag: 28.09.2011
(51) Int. Cl.: C23C 14/34, C23C 14/35, H01J 37/34

(54) **BESCHICHTEN VON SUBSTRATEN MIT EINER LEGIERUNG MITTELS KATHODENZERSTÄUBUNG**
COATING SUBSTRATES WITH AN ALLOY BY MEANS OF CATHODE SPUTTERING
REVÊTEMENT DE SUBSTRATS AVEC UN ALLIAGE PAR PULVÉRISATION CATHODIQUE

(30) Priorität: 28.09.2010 DE 102010046780
(43) Veröffentlichungstag der Anmeldung: 07.08.2013
(73) Patentinhaber: Singulus Technologies AG, 63796 Kahl am Main (DE)
(72) Erfinder: MAASS, Wolfram, 63589 Linsengericht (DE); OCKER, Berthold, 63454 Hanau (DE); LANGER, Jürgen, 63075 Offenbach (DE)
(74) Vertreter: Vossius & Partner Patentanwälte Rechtsanwälte mbB
(86) Internationale Anmeldenummer: PCT/EP2011/066895
(87) Internationale Veröffentlichungsnummer: WO 2012/041920

(56) Entgegenhaltungen:
- EP-A1- 1 254 970
- WO-A2-01/94659
- US-A- 4 505 798
- US-A- 4 610 774
- US-A- 4 971 674
- US-A- 5 190 630
- US-A1- 2003 085 114
- US-A1- 2004 206 620
- US-B1- 6 464 844
- US-B1- 6 692 619
- US-B1- 6 709 557

## Beschreibung

Die vorliegende Erfindung betrifft die Herstellung von dünnen Schichten auf einem Substrat mittels Kathodenzerstäubung, insbesondere Magnetron-Kathodenzerstäubung (Sputtern). Die vorliegende Erfindung betrifft insbesondere das Beschichten eines Substrats mit einer Legierung, die eine definierte Legierungszusammensetzung bzw. eine definierte Änderung der Legierungszusammensetzung über die Fläche des Substrats, also einen definierten Konzentrationsgradienten, der Materialien der Legierung aufweist.

Ein Verfahren und eine Vorrichtung zum Beschichten eines Substrats durch Kathodenzerstäubung ist beispielsweise aus der WO 03/071579 bekannt. Hier wird eine Zerstäubungskathode offenbart, mit der eine Beschichtung eines Substrats insbesondere mit magnetischen bzw. magnetisierbaren Werkstoffen hergestellt werden kann. Die Zerstäuberkathode weist einen Kathodengrundkörper, ein darauf angeordnetes Target und eine hinter dem Target angeordnete Magnetanordnung auf. Um die leichte Magnetisierungsachse des aufzubringenden Werkstoffes ausrichten zu können, weist die Zerstäubungskathode weiterhin eine Einrichtung zum Erzeugen eines externen Magnetfelds mit im wesentlichen parallel verlaufenden Magnetfeldlinien in der Ebene des Substrats auf. Die Kathode ist vorzugsweise eine Langkathode mit einer Länge, die zumindest einem Durchmesser des Substrats entspricht. Zum Erreichen einer homogenen Beschichtung wird das zu beschichtende Substrat während der Kathodenzerstäubung unter der Langkathode in eine Richtung quer zu der Längsseite der Langkathode in der Substratebene bewegt.

Um in Anwendungen von derart aufgebrachten dünnen Schichten bestimmte Schichteigenschaften zu erreichen, kann eine ganz bestimmte Zusammensetzung der abgeschiedenen Schicht erforderlich sein.

Beispiele für derartige Schichten sind Ni(₁₋ₓ)Feₓ, mit x = 0.18 ... 0.45 oder Pt(₁₋ₓ)Mnₓ, mit x ≈ 0.5, wobei bestimmte Eigenschaften der Schichten vom genauen Wert x abhängen. Um solche Schichten herzustellen, werden Targets verwendet, die aus der aufzubringenden Legierung im gewünschten Verhältnis bestehen.

Im Bereich der Forschung und Entwicklung ist es aber in vielen Fällen gar nicht bekannt, welche Legierungszusammensetzung einer bestimmten Schicht für den speziellen Zweck die besten Ergebnisse erzielt. Ein weiteres Problem - vor allem in Fällen von Materialien mit stark unterschiedlicher Atom-Masse - besteht darin, dass sich bei der Kathodenzerstäubung die Legierungszusammensetzung während der Abscheidung ändern kann. Die Legierungszusammensetzung der auf dem Substrat abgeschiedenen Schicht kann also im Vergleich zur Legierungszusammensetzung im Sputter-Target mehr oder minder verändert sein, z.B. bei PtMn. Darüber hinaus hängt diese Veränderung von den Parametern des Beschichtungsprozesses ab, z.B. dem Prozeß-Druck, der Beschichtungsrate, etc. Da es letztlich auf die Zusammensetzung der Legierung auf dem Substrat ankommt, ist es oft schwierig, die optimale Zusammensetzung der Legierung des Sputter-Targets festzulegen.

Eine häufig benutzte, aber sehr unflexible Methode, Legierungen von dünnen Schichten einzustellen, die mit Kathodenzerstäubung abgeschieden werden, beruht auf der Verwendung einer Reihe von Sputter-Targets mit unterschiedlichen, ggf. sehr eng beieinander liegenden Legierungszusammensetzungen. Diese Methode ist vor allem bei teuren Materialien (PtMn, FePt, usw.) sehr kostspielig. Mehrere Targets mit entsprechenden Legierungen müssen hergestellt bzw. gekauft werden, wobei nach entsprechenden Reihenversuchen mit den verschiedenen Targets letztlich nur ein Target davon in die Nähe der optimalen Legierung kommt und wirklich verwendet werden kann.

Bei diesen Reihenversuchen müssen die entsprechenden Targets in die entsprechenden Vakuum-Anlagen ein- und ausgebaut werden, mit einem damit verbundenen hohen Zeitaufwand.

Die Einstellung der Legierungszusammensetzung von Legierungsschichten auf einem Substrat mit Hilfe des Beschichtungsprozesses selbst, d.h. durch von außen einstellbare Veränderungen des Beschichtungsprozesses und/oder der Beschichtungsgeometrie ist im Vergleich dazu ein deutlich einfacheres, schnelleres und in der Regel auch preiswerteres Verfahren.

Ein in diesem Sinne sehr häufig angewendetes Verfahren ist das sogenannte Co-Sputtern. Dabei wird das Substrat typischerweise gleichzeitig durch zwei (oder mehr) Sputterkathoden beschichtet, die jeweils mit unterschiedlichen Targetmaterialien arbeiten. Durch Ändern des Verhältnisses der Leistung beider Kathoden, wird auch das Verhältnis der beiden Materialmengen, d.h. die Legierungszusammensetzung, auf dem Substrat verändert. Vor allem bei größeren Substraten ist es bei dieser Technik schwierig, eine homogene Legierung auf dem Substrat zu erzeugen und gleichzeitig eine homogene Schichtdicke zu erreichen. Zur Verbesserung der Schichtdickenhomogenität wird das Substrat während der Beschichtung rotiert.

Bei einem anderen Verfahren werden Mehrfachschichten der beiden (oder auch mehr als zwei) Materialien abwechselnd auf das Substrat aufgebracht und danach - typischerweise im Vakuum - einer geeignet hohen Temperatur ausgesetzt ("getempert"). Dadurch soll ein Diffusionsprozeß in Gang gesetzt werden, der eine Mischung bzw. Homogenisierung der Materialien und damit letztlich die gewünschte Legierung erzeugt. Die Legierungszusammensetzung wird durch die Wahl der anfänglichen Schichtdicken eingestellt. Voraussetzung für das Funktionieren dieses Verfahrens ist, dass der Diffusionsvorgang bei geeigneten Temperaturen und in sinnvoll kurzer Zeit durchgeführt werden kann. Dieses Verfahren ist daher auf eine begrenzte Auswahl von Materialien - auch unter den Metallen - beschränkt.

Weiterer Stand der Technik ist aus US 5 190 630 A, US 4 505 798 A, EP 1 626 432 A1, US 2005/0274610 A1, US 4971674 A und WO 03/71579 bekannt.

Es ist eine Aufgabe der Erfindung, eine Vorrichtung und ein Verfahren bereitzustellen, mit denen eine dünne Schicht einer homogenen Legierung auf ein Substrat aufgebracht werden kann, wobei die Legierungszusammensetzung eingestellt bzw. gesteuert verändert werden kann. Eine weitere Aufgabe der Erfindung besteht darin, die Legierungszusammensetzung auf dem Substrat örtlich zu variieren, also einen Legierungsgradienten herzustellen, so dass sich die jeweilige Konzentration der Legierungsbestandteile in der aufgebrachten Schicht mit der Position auf dem Substrat kontrolliert ändert. Sowohl eine Veränderung der Legierungszusammensetzung als auch das Einstellen des Legierungsgradienten führt zu einem Verändern des Legierungsverhältnis.

Diese Aufgaben werden erfindungsgemäß mit dem Verfahren nach Anspruch 1, der Vorrichtung nach Anspruch 4 und der Verwendung nach Anspruch 7 gelöst. Die vorliegende Erfindung basiert auf dem Grundgedanken, ein Substrat, das eine Breite und eine Länge hat, wobei Breite und Länge gleich sein können, mittels Mangetron-Kathodenzerstäubung mit einer Legierung zu beschichten, wobei ein Target und eine von dem zu beschichtenden Substrat aus gesehen hinter dem Target angeordnete Magnetron-Magnetanordnung verwendet werden. Erfindungsgemäß wird ein spezielles Target verwendet, dessen Oberfläche aus zumindest zwei Abschnitten jeweils aus unterschiedlichen Materialien aufgebaut ist, die die Legierung der Schicht bilden sollen. Die unterschiedlichen Materialien sind auf der Oberfläche des Targets dabei so angeordnet, dass im Betrieb in einem Erosionsabschnitt bzw -graben Material aus beiden Abschnitten gleichzeitig abgetragen wird. Durch geeignete Positionierung des Erosionsabschnitts bzw. -grabens relativ zur Grenzlinie zwischen den beiden Materialabschnitten des Targets wird der Anteil der beiden durch den Erosionsabschnitt bzw. -graben erfassten Targetabschnitte und damit entsprechend das Legierungsverhältnis auf dem Substrat verändert. Diese Positionierung erfolgt erfindungsgemäß durch Verschieben, Verdrehen und/oder Verkippen der Magnetanordnung relativ zur Materialgrenzlinie des Targets.

Verläuft die Grenzlinie zwischen den beiden Abschnitten parallel zur Richtung des Verlaufs des Erosionsabschnitts, werden über die Länge des Erosionsabschnitts konstante Anteile der beiden Materialien abgetragen, und es entsteht auf dem Substrat eine konstante Legierung in der Längsrichtung des Erosionsabschnitts. Durch Verschieben des Erosionsabschnitts quer zur Grenzlinie kann das Legierungsverhältnis verändert werden. Findet das Verschieben des Erosionsabschnitts zeitlich vor der Substratbewegung statt, so wird die Legierungszusammensetzung eingestellt. Ein Verschieben des Erosionsabschnitts bei gleichzeitiger Substratverschiebung im laufenden Betrieb führt zur Ausbildung eines Legierungsgradienten auf dem Substrat entlang der Bewegungsrichtung des Substrats.

Verläuft die Grenzlinie zwischen den beiden Abschnitten in einem spitzen Winkel, beispielsweise kleiner als 20°, zur Richtung des Erosionsabschnitts, so entsteht auf dem zu beschichteten Substrat ein Legierungsgradient in der Richtung des Erosionsabschnitts, da entlang des Verlaufs des Erosionsabschnitts unterschiedliche Mengen der beiden Materialien abgetragen werden und so auf einer Seite mehr von dem Material des einen Abschnitts und auf der anderen Seite mehr von dem Material des anderen Abschnitts abgetragen wird, wobei dazwischen ein kontinuierlicher Übergang der Legierungszusammensetzung erreicht wird.

Eine Veränderung des Legierungsverhältnisses kann auch dadurch erreicht werden, dass ein Winkel β zwischen der Oberfläche der Magnetanordnung und der dem Substrat zugewandten Oberfläche des Targets eingestellt wird.

Erfindungsgemäß kann das Plasma im Querschnitt auch kreisförmig oder elliptisch sein, so dass der Erosionsabschnitt sich auch entsprechend kreisförmig bzw. elliptisch ausbildet. Durch Verschieben des Plasmas quer zur Targetgrenzlinie wird die Legierungszusammensetzung auf dem beschichteten Substrat verändert. Soll eine Schicht aus einer Legierung mit mehr als zwei Materialien gebildet werden, sind verschiedene Anordnungen der Abschnitte aus den verschiedenen Materialien auf der Targetoberfläche denkbar. Beispielsweise können die Abschnitte aus den verschiedenen Materialien sternförmig auf der Targetoberfläche angeordnet sein. Durch Verschieben des kreisförmigen bzw. elliptischen Erosionsabschnitts bezüglich einer solchen sternförmigen Anordnung parallel zur Oberfläche des Targets können die jeweiligen Anteile der die Legierung bildenden Materialien frei gewählt werden.

Die Veränderung des Legierungsverhältnisses kann gemäß einer Ausführungsform der Erfindung durch Verschieben der Magnetanordnung bezüglich der Oberfläche des Substrats und/oder Verschieben des Substrats bezüglich der Oberfläche der Magnetanordnung, vorzugsweise durch Verschieben in zueinander senkrechte Richtungen erfolgen. Findet das Verschieben der Magnetanordnung vor dem Verschieben des Substrats statt, so wird die Legierungszusammensetzung eingestellt. Ein Verschieben der Magnetanordnung bei gleichzeitiger Substratverschiebung führt zur Ausbildung eines Legierungsgradienten auf dem Substrat entlang der Relativbewegung.

Gemäß einer bevorzugten Ausführungsform der Erfindung erfolgt das Verändern des Legierungsverhältnisses im Falle einer langgestreckten Magnetron-Zerstäubungskathode, d.h. Langkathode, die sich über die Breite des Substrats erstreckt und einer langgestreckten Magnetanordnung, die eine Breite und eine Länge hat, durch Ausrichten der Länge der Magnetanordnung parallel oder in einem spitzen Winkel α zur Grenzlinie auf der Targetoberfläche.

Erfindungsgemäß kann das Verändern des Legierungsverhältnisses durch Verkippen der Magnetanordnung um eine Achse bezüglich der Targetoberfläche um einen Winkel β erfolgen. Das Verkippen der Magnetanordnung verändert die Rate des Targetabtrags auf den beiden längs des Targets ausgebildeten Erosionsgräben relativ zueinander, so dass die Zusammensetzung bzw. Konzentration der Legierung und/oder der Legierungsgradient variiert werden kann.

In einer Magnetron-Zerstäubungskathode werden häufig Permanentmagnete für die MagnetAnordnung verwendet. Erfindungsgemäß ist es alternativ auch möglich, Elektromagneten anstelle von Permanentmagneten zu verwenden.

Gemäß einer bevorzugten Ausführungsform der Erfindung ist das Target im wesentlichen rechteckig. Beim Beschichten wird das zu beschichtende Substrat unter dem Target auf der der Magnetanordnung abgewandten Seite in einer Richtung parallel zur Querrichtung des Targets bewegt.

Damit die Grenzlinie zwischen den beiden Abschnitten in einem spitzen Winkel α zur Richtung des Erosionsabschnitts verläuft, können die Abschnitte der Oberfläche des Targets trapezförmig sein, wobei diese trapezförmigen Abschnitte derart angeordnet sind, dass sich auf der Oberfläche des rechteckigen Targets Streifen unterschiedlicher Materialien ergeben, deren Grenzlinien gegenüber der Längsseite des Targets um einen Winkel verkippt sind. Beim Aufbau einer typischen Vorrichtung zur großflächigen Kathodenzerstäubung und insbesondere zur Magnetron-Kathodenzerstäubung mit Langkathode bildet sich auf dem Target ein "Rennbahn"-förmiger Erosionsabschnitt ("Race track") aus, wobei zwei langgestreckte Gräben in der Längsrichtung des Targets entstehen. Für diese beiden Gräben sollte ein gleichartiger Übergang zwischen den Materialien bereitgestellt werden. Vorzugsweise werden daher drei trapezförmige Abschnitte vorgesehen. Auf diese Weise kann ein Aufbau erzielt werden, bei dem jeweils die Grenzlinien zwischen den Abschnitten unterschiedlicher Materialien in einem spitzen Winkel α zur Richtung der geraden Abschnitte des Rennbahn-förmigen Erosionsabschnitts überstreichen, so dass an einem Ende mehr Material des einen Abschnitts und am anderen Ende mehr Material des anderen Abschnitts abgetragen wird. Bei einer Relativbewegung des Substrats im wesentlichen senkrecht zur Längsrichtung der Langkathode erhält man eine entsprechende unterschiedliche Legierungszusammensetzung in Querrichtung des Substrats.

Um dagegen eine konstante Legierungszusammensetzung über die Länge des Targets und damit über die Breite des Substrats zu erreichen, muss sichergestellt werden, dass der Erosionsabschnitt im wesentlichen parallel zur und entlang der Grenzlinie zwischen den beiden Abschnitten verläuft. Hierzu ist es bevorzugt, ein Target mit einer Oberfläche zu verwenden, die aus mehreren einzelnen rechteckförmigen Abschnitten zusammengesetzt ist, so dass sich die Materialien der Abschnitte abwechseln. So ergeben sich auf der Oberfläche des Targets Streifen unterschiedlicher Materialien, deren Grenzlinien sich parallel zur Längsrichtung des Targets erstrecken. Bei Verwendung von vier Abschnitten, von denen jeweils zwei aus dem gleichen Material sind, können auf dem Target zwei gleichartige Grenzlinien zwischen den beiden Materialien erreicht werden, was bei einem Rennbahn-förmigen Aufbau des Erosionsabschnitts erwünscht ist. Durch Verschieben des Erosionsabschnitts in der Querrichtung des Targets, also senkrecht zu den Grenzlinien zwischen den Abschnitten, kann das Verhältnis zwischen den beiden Materialien eingestellt werden, je nachdem wie groß der Anteil des Erosionsabschnitts ist, der auf dem einen bzw. dem anderen Materialabschnitt des Targets liegt.

Um den Aufbau der Targetoberfläche aus verschiedenen Abschnitten zu erreichen, kann das Target aus mehreren Einzelstücken zusammengesetzt sein, deren Oberflächen die Abschnitte der Oberfläche des Targets bilden. Hierbei besteht zumindest eines der Einzelstücke aus dem ersten Material und zumindest ein weiteres der Einzelstücke aus dem zweiten Material. Statt eines Aufbaus aus verschiedenen Target-Einzelstücken ist es auch möglich, ein Target aus einem der Materialien herzustellen und an den entsprechenden gewünschten Stellen eine Schicht aus dem zweiten Material aufzubringen und so die verschiedenen Abschnitte zumindest an der Targetoberfläche zu bilden. Dies ist insbesondere dann vorteilhaft, wenn eines der beiden Materialien der gewünschten Legierung nicht-ferromagnetisch ist. In diesem Fall wird das Target aus dem ferromagnetischen Material hergestellt und das zweite nicht-ferromagnetische Material auf das Grundmaterial aufgebracht.

Auch ist es möglich, Legierungen aus mehr als zwei Materialien herzustellen. Hierzu müssen mehrere Abschnitte aus den gewünschten Materialen geeignet auf dem Target angeordnet werden.

Die Position des Erosionsabschnitts, die durch die Position der Magnetron-Magnetanordnung bestimmt wird, kann durch Bewegen dieser Magnetanordnung relativ zur Oberfläche des Targets verschoben werden, beispielsweise in einer Richtung quer zur Längsrichtung bzw. zur Grenzlinie des Targets. Durch eine solche Bewegung kann bei Erzeugung eines Konzentrationsgradienten mit dem entsprechend ausgebildeten Target die Steilheit des Konzentrationsgradienten eingestellt werden.

Erfindungsgemäß kann auf dem Substrat bezogen auf die Längsrichtung der Langkathode ein Legierungsgradient in der Legierungsschicht erzeugt werden, d.h. eine Änderung der Legierungszusammensetzung, z.B. einer binären Legierung, bezogen auf die Position im beschichteten Substrat. Erfindungsgemäß kann die Steilheit des Legierungsgradienten bzw. der Wert des Mittelwerts der Materialkonzentration durch eine Verstellung von Maschinenparametern eingestellt werden. Weiterhin kann auch eine definierte homogene Legierungs-Konzentration über die Fläche des Substrats mit verschiedenen Werten eingestellt werden. Das Legierungsverhältnis wird in Abhängigkeit von der Position der Magnetron-Zerstäubungskathode über dem Substrat verändert.

Die vorliegende Erfindung wird im Folgenden unter Bezugnahme auf die beigefügten Zeichnungen näher erläutert. Es zeigen:
Fig. 1a eine schematische Ansicht der erfindungsgemäß verwendeten Kathodenzerstäubungs-Vorrichtung und Fig. 1b in Draufsicht die Bewegung des zu beschichtenden Substrats während der Beschichtung;
Fig. 2a den bei der Magnetron-Kathodenzerstäubung entstehenden Erosionsabschnitt auf der Oberfläche des Targets, Fig. 2b einen Abschnitt des Erosionsabschnitts auf der Oberfläche des erfindungsgemäßen Targets und Fig. 2c eine Darstellung zur Erläuterung der Relativbewegung des zu beschichtenden Substrats und der Magnetanordnung während der Beschichtung in einer Draufsicht gemäß einer weiteren Ausführungsform der Erfindung;
Fig. 3a und 3b jeweils eine Draufsicht des Aufbaus eines Targets gemäß einer weiteren Ausführungsform der Erfindung;
Fig. 4 eine schematische Seitenansicht der erfindungsgemäßen Beschichtungsvorrichtung zur Darstellung der Verschiebung der Magnetanordnung;
Fig. 5 eine schematische Seitenansicht der erfindungsgemäßen Beschichtungsvorrichtung zur Darstellung der Verkippung der Magnetanordnung;
Fig. 6 eine schematische Draufsicht eines kreisförmigen Substrats mit einer erfmdungsgemäß hergestellten Beschichtung mit einem Konzentrationsgradienten;
Fig. 7a und 7b zwei Beispiele der Legierungszusammensetzung bezüglich der Substratposition mit zwei verschiedenen Steigungen;
Fig. 8 die Legierungszusammensetzung bezüglich der Substratposition mit einem definierten Mittelwert;
Fig. 9a eine Draufsicht des Aufbaus eines Targets einer weiteren erfindungsgemäßen Ausführungsform und Fig. 9b eine schematische Darstellung einer erfindungsgemäßen Beschichtungsvorrichtung mit diesem Target;
Fig. 10 zwei bezüglich der Substratposition konstante Legierungszusammensetzungen; und
Fig. 11 schematisch den Querschnitt eines Targets gemäß einer weiteren Ausführungsform der vorliegenden Erfindung.

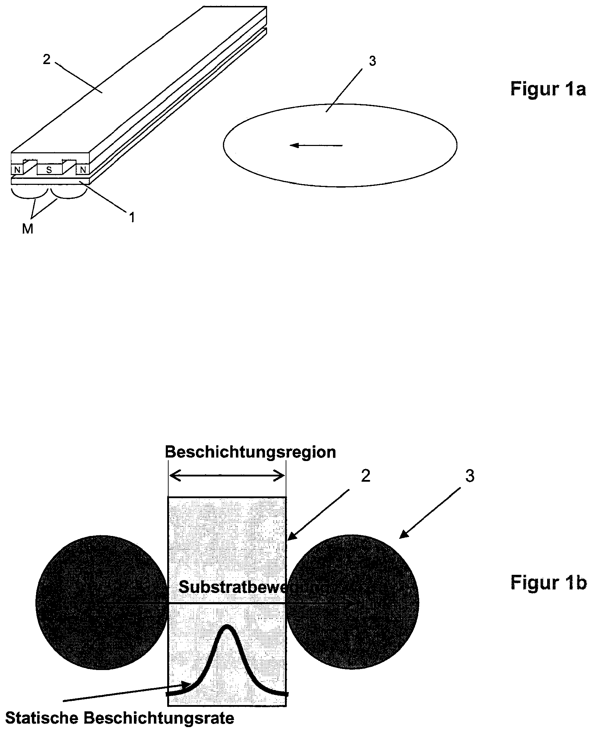

Bei der vorliegenden Erfindung wird von der sogenannten Linear Dynamic Deposition (LDD) Technologie ausgegangen, wie sie beispielsweise auch in Beschichtungsanlagen vom Typ TIMARIS der Singulus Technologies AG angewendet wird. Das verwendete Grundprinzip ist beispielsweise aus der oben bereits genannten WO 03/071579 bekannt. Fig. 1 zeigt schematisch einen hierbei verwendeten Aufbau einer Anlage zur Kathodenzerstäubung, wie sie auch gemäß der vorliegenden Erfindung verwendet werden kann. Die Vorrichtung in Form einer Langkathode weist ein Lang-Target 1 und eine darüber angeordnete entsprechend langgestreckte Magnetron-Magnetanordnung 2 auf. Durch die Magnetanordnung 2 mit Magnetpolen N-S-N wird ein Magnetfeld erzeugt, das in der Figur 1a durch die unter dem Target 1 angedeuteten Magnetfeldlinien M dargestellt wird. Auf ein aus Richtung der Magnetfeldanordnung gesehen unter dem Target 1 angeordnetes Substrat 3 kann eine Schicht aus dem Material des Targets 1 aufgebracht werden. Fig. 1b illustriert in einer Draufsicht die in einer Beschichtungsregion unter dem Target 1 erreichte statische Beschichtungsrate. Um eine homogene Schicht auf dem Substrat 3 zu erzeugen, wird das Substrat 3 in seiner Ebene unter dem Target verfahren, wie es in den Figuren 1a und 1b durch Pfeile angedeutet ist.

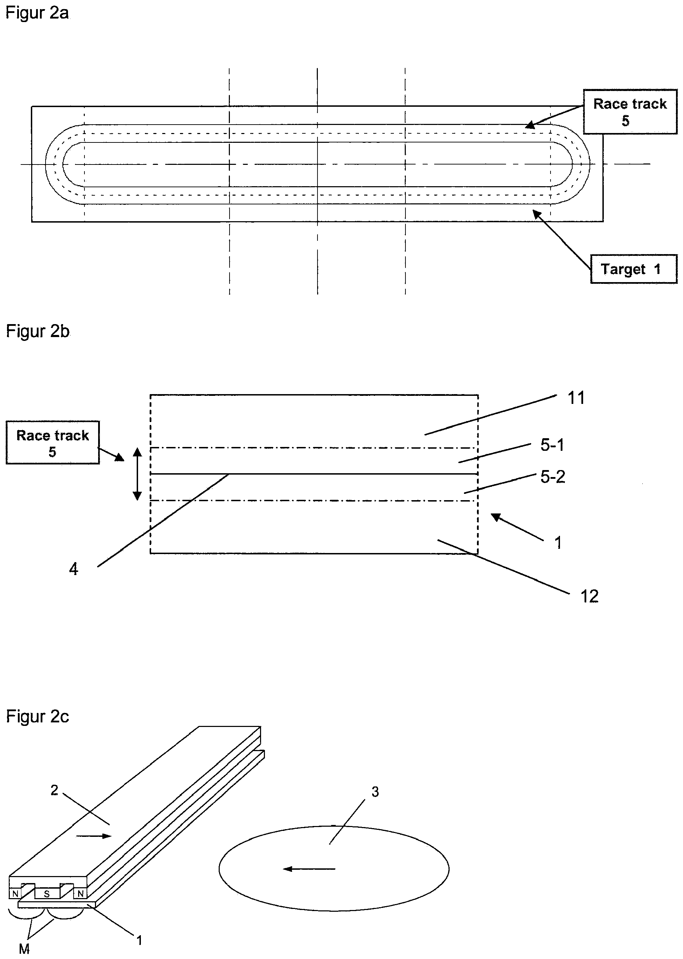

In Fig. 2a ist ein Target gezeigt, wie es in der Beschichtungsvorrichtung gemäß Fig. 1a verwendet werden kann. Das Target hat in der in Fig. 2a gezeigten Draufsicht eine rechteckige Form und weist entsprechend eine Längsseite und eine Querseite auf, die eine Längsrichtung der Längskathode und eine Querrichtung definieren. Durch die Anordnung der Magnetanordnung 2 hinter dem Target, wie es in Fig. 1a gezeigt ist, ergibt sich im Betrieb ein "Rennbahn"-föumiger Erosionsabschnitt bzw -graben 5, der auch als Race Track bezeichnet wird. In dieser Position bzw. in dem sich ergebenden Graben wird Material vom Target abgetragen, das dann auf dem Substrat abgeschieden werden kann.

Gemäß der vorliegenden Erfindung wird in der Kathodenzerstäubungs-Vorrichtung ein Target verwendet, dessen Oberfläche zumindest zwei verschiedene Materialien aufweist. Fig. 2b zeigt beispielhaft eine Draufsicht auf die Oberfläche eines solchen Targets 1 mit einem ersten Abschnitt 11 aus einem ersten Material und einem zweiten Abschnitt 12 aus einem zweiten Material. Die beiden aneinander angrenzenden Abschnitte 11 und 12 bilden eine Grenzlinie 4. Im Betrieb bildet sich ein Erosionsabschnitt (Race Track) 5 auf der Oberfläche des Targets, wobei ein Abschnitt des Erosionsabschnitts 5 in Fig. 2b gezeigt ist, dessen Ausdehnung in Breitenrichtung durch strichpunktierte Linien angedeutet ist. Um eine Legierung auf dem Substrat zu bilden, muss der Erosionsabschnitt 5 so angeordnet sein, dass beide Materialien gleichzeitig abgetragen werden, d.h. die Grenzlinie 4 liegt im Bereich des Erosionsabschnitts 5. Dieser Erosionsabschnitt 5 wird durch die Grenzlinie 4 des Targets in zwei Erosionsteilabschnitte 5-1 und 5-2 (in Fig. 2b oberhalb bzw. unterhalb der Grenzlinie 4) unterteilt, in denen das erste bzw. zweite Legierungsmaterial abgetragen wird. In Fig. 2b ist die Situation gezeigt, bei der der Erosionsabschnitt etwa symmetrisch zur Grenzlinie liegt und die beiden Erosionsteilabschnitte etwa gleich breit sind, so dass jeweils im Wesentlichen gleich viel der beiden Materialien abgetragen wird.

Wird die Position des Erosionsabschnitts 5 relativ zur Grenzlinie 4 verschoben, bevor die Bewegung des Substrats im laufenden Betrieb stattfindet, so kann erreicht werden, dass das eine oder andere Material vermehrt abgetragen und die Legierungszusammensetzung eingestellt wird. Gleichzeitiges Verschieben der Magnetanordnung 2 und somit des Erosionsabschnitts und des Substrats im laufenden Betrieb, vorzugsweise in zueinander senkrechte Richtungen, führt zu einem Legierungsgradienten in Bewegungsrichtung des Substrates, wie in Fig. 2c gezeigt. Die Konzentration des ersten Materials nimmt kontinuierlich ab, während die Konzentration des zweiten Materials kontinuierlich zunimmt.

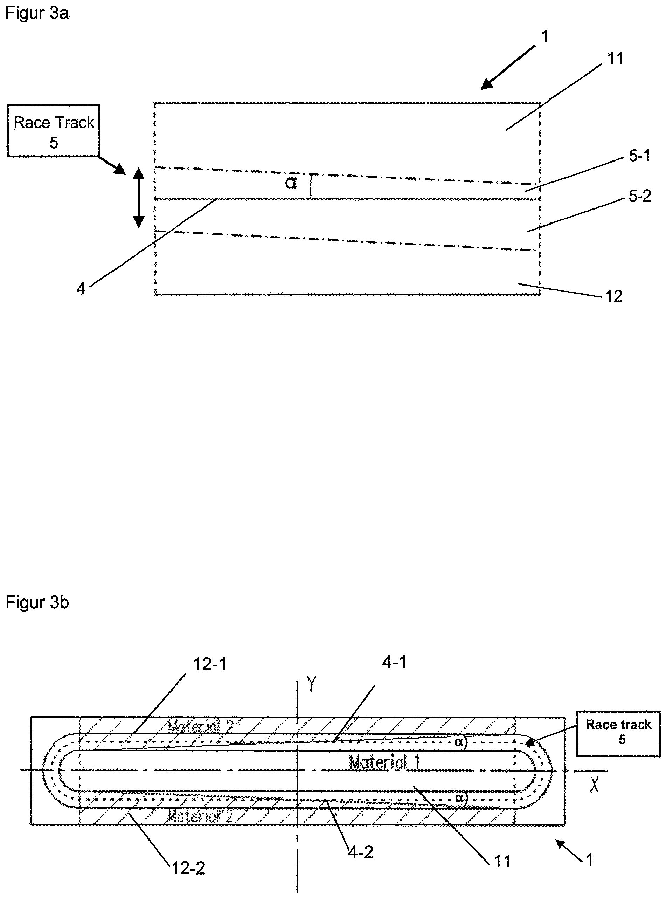

Bei der Ausführungsform gemäß Fig. 3a ist die Richtung des Erosionsabschnitts 5 auf dem Target 1 gegenüber der Grenzlinie 4 um einen spitzen Winkel α geneigt, so dass die Breite der Erosionsteilabschnitte 5-1 und 5-2 in Längsrichtung des Targets 1 variiert. Dadurch ergibt sich je nach Position auf dem Target 1 eine unterschiedliche Zusammensetzung der Legierung.

In Fig. 3b ist ein Target gemäß einer weiteren Ausführungsform der vorliegenden Erfindung gezeigt, das aus drei Einzelstücken 11, 12-1, 12-2 aufgebaut ist, die in der in Fig. 3b gezeigten Draufsicht jeweils eine trapezförmige Form haben; jeweils aneinandergrenzende Teilstücke sind aus einem unterschiedlichen Material hergestellt: Teilstück 12-1 (Material 2), Teilstück 11 (Material 1) und Teilstück 12-2 (Material 2). Die so gebildeten Grenzlinien 4-1 und 4-2 zwischen den Abschnitten mit unterschiedlichen Materialien sind um einen spitzen Winkel α gegenüber dem Erosionsabschnitt 5 geneigt. Durch die Trapezform der Einzelstücke, aus denen das Target gemäß Fig. 3 zusammengesetzt ist, und deren Anordnung werden auf den langen Teilstücken des Race Tracks 5 beide Materialien gleichzeitig, jedoch in unterschiedlichen Mengen abgetragen. Insbesondere wird zunächst bezüglich der Längsrichtung auf der einen, nämlich der in den Fig. 3a und 3b rechten Seite des Targets mehr vom Material 1 zerstäubt und auf der anderen, der linken Seite, mehr vom Material 2. Wird nun ein Substrat, dessen Durchmesser höchstens der Länge des Targets entspricht, während der Beschichtung entlang der Querrichtung des Targets, also in der in Fig. 3b eingezeichneten Y-Richtung unter dem Target hindurch bewegt, ergibt sich auf dem Substrat in X-Richtung ein Gradient der Konzentration der beiden Materialien, wobei im Bild der Fig. 3b auf der linken Seite das Material 2 und auf der rechten Seite das Material 1 überwiegt. Von links nach rechts nimmt die Konzentration des Materials 2 kontinuierlich ab, während die Konzentration des Materials 1 kontinuierlich zunimmt.

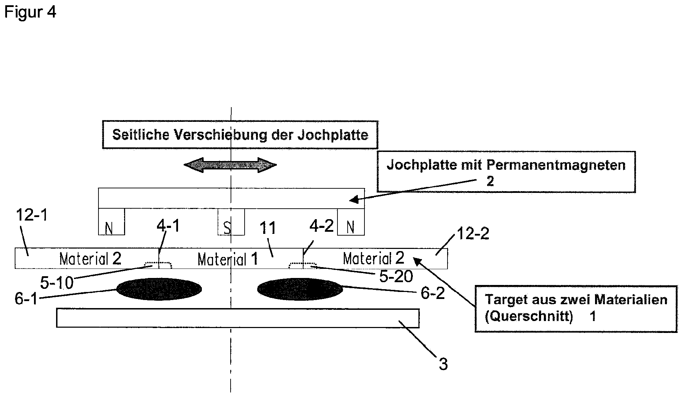

In Fig. 4 ist schematisch eine Querschnittsansicht der Beschichtungsvorrichtung gemäß einer Ausführungsform der Erfindung gezeigt. Der in Fig. 4 gezeigte Querschnitt des in Fig. 3b gezeigten Targets ist ein Schnitt entlang der Y-Achse aus Fig. 3b. Durch die über dem Target angeordnete Magnetanordnung 2, die eine Jochplatte mit Permantmagneten mit Polschuhen N, S und N aufweist, wird ein Magnetfeld erzeugt. Unter dem Target entsteht ein Niederdruck-Plasma 6-1 und 6-2 aus den Materialien des Targets. Dort wird das Substrat 3 zum Beschichten angeordnet. Durch eine Bewegung der Permanent-Magnete 2, wie sie durch die Pfeile oberhalb der Magnetanordnung gezeigt ist, können die auf dem Substrat entstehenden Erosionsabschnitte 5-10 und 5-20, die durch die Magnetanordnung erzeugt werden, senkrecht zur Längsausdehnung des Targets (in der Fig. 4 nach links oder rechts) verschoben werden.

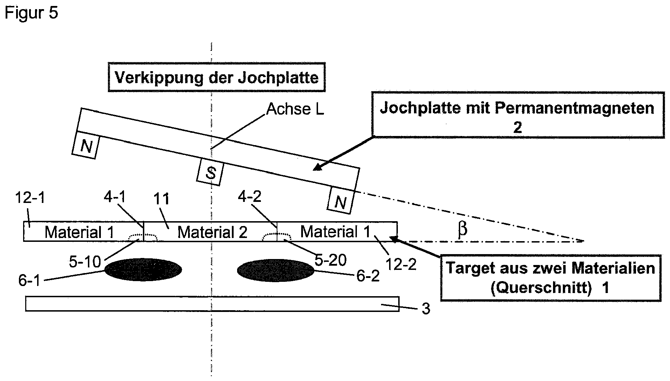

Gemäß Fig. 5 kann die Jochplatte 2 mit der Magnetanordnung um die Längsachse L der Langkathode (d.h. um eine Achse senkrecht zur Bildebene der Fig. 5) verkippt werden. Durch diese Verkippung kann die Rate des Targetabtrags auf den beiden längs des Targets 1 ausgebildeten Erosionsabschnitten 5-10 und 5-20 relativ zueinander und dementsprechend das Legierungsverhältnis und dessen Gradient auf dem Substrat verändert werden.

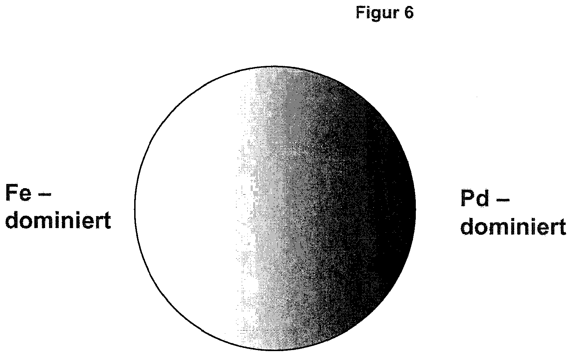

In Fig. 6 ist beispielhaft eine durch die oben beschriebene Anwendung der vorliegenden Erfindung auf einem Substrat sich ergebende Materialverteilung gezeigt. Durch eine Beschichtung mit einem Target, wie es in Fig. 3 gezeigt ist, wobei das Material 1 in diesem Falle Palladium und das Material 2 Eisen ist, ergibt sich auf der Oberfläche des Substrats 3 nach der Beschichtung die in Fig. 6 gezeigte Konzentrationsverteilung. Während auf der linken Seite des Substrats hauptsächlich Eisen abgeschieden wird, ist auf der rechten Seite die Palladiumkonzentration hoch. Dazwischen ergibt sich ein kontinuierlicher Übergang, der durch eine Abnahme der Eisenkonzentration und eine Zunahme der Palladiumkonzentration gekennzeichnet ist.

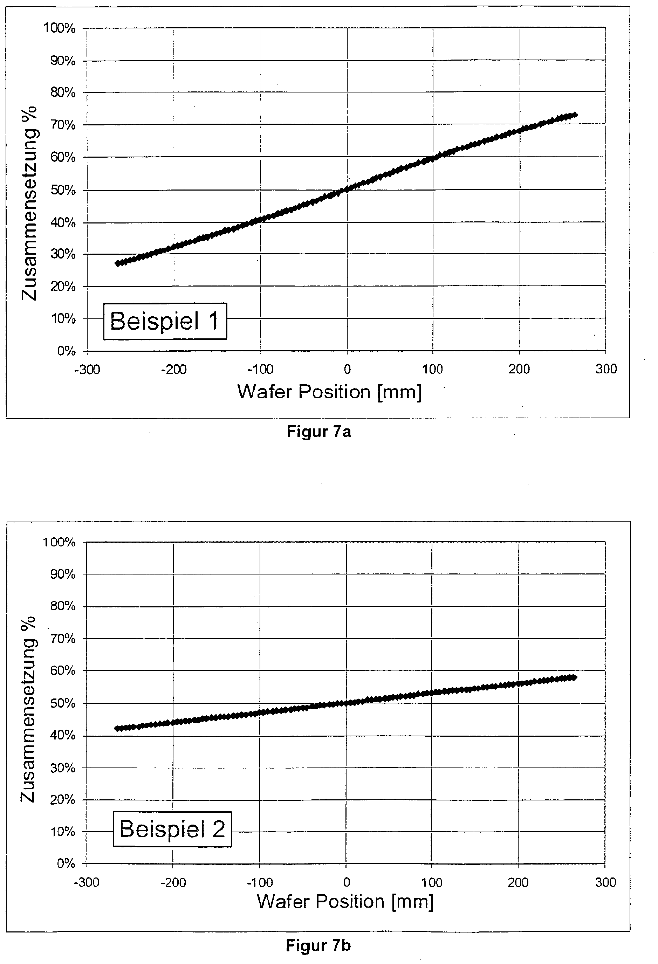

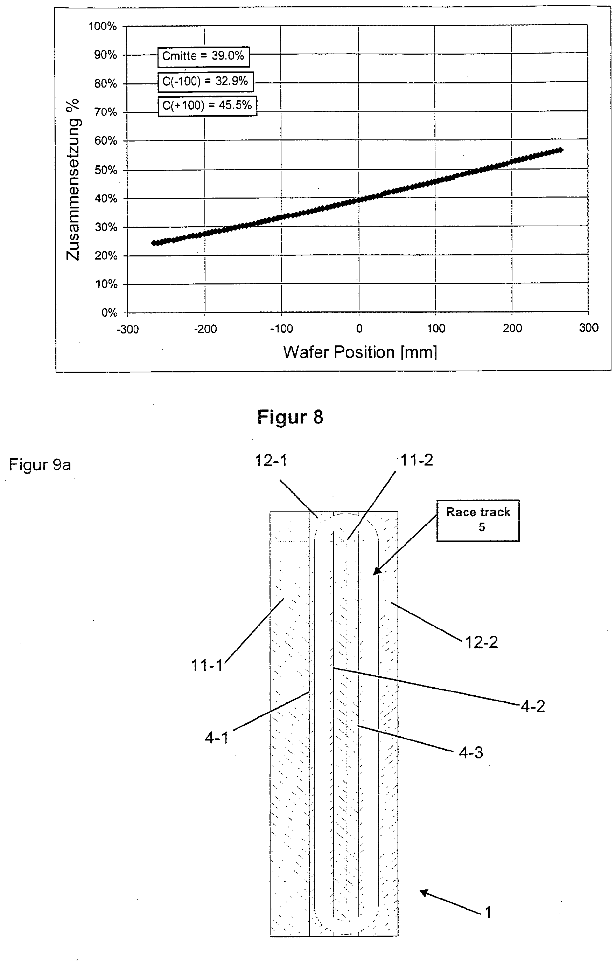

Die Figuren 7a und 7b zeigen die Konzentration eines der Materialien der Legierung entlang des Durchmessers eines Substrats, wie es in Fig. 6 am Beispiel von Palladium gezeigt ist. Gemäß den Figuren 7a und 7b nimmt die Konzentration (z.B. die Pd-Konzentration) kontinuierlich von links nach rechts zu. Die unterschiedliche Steigung der Konzentration ist durch eine seitliche Verschiebung der Magnetanordnung erreicht worden, wie sie in Fig. 4 gezeigt ist. In Fig. 8 ist gezeigt, dass durch Verkippen der Magnetanordnung, wie sie in Fig. 5 gezeigt ist, der relative Anteil eingestellt werden kann.

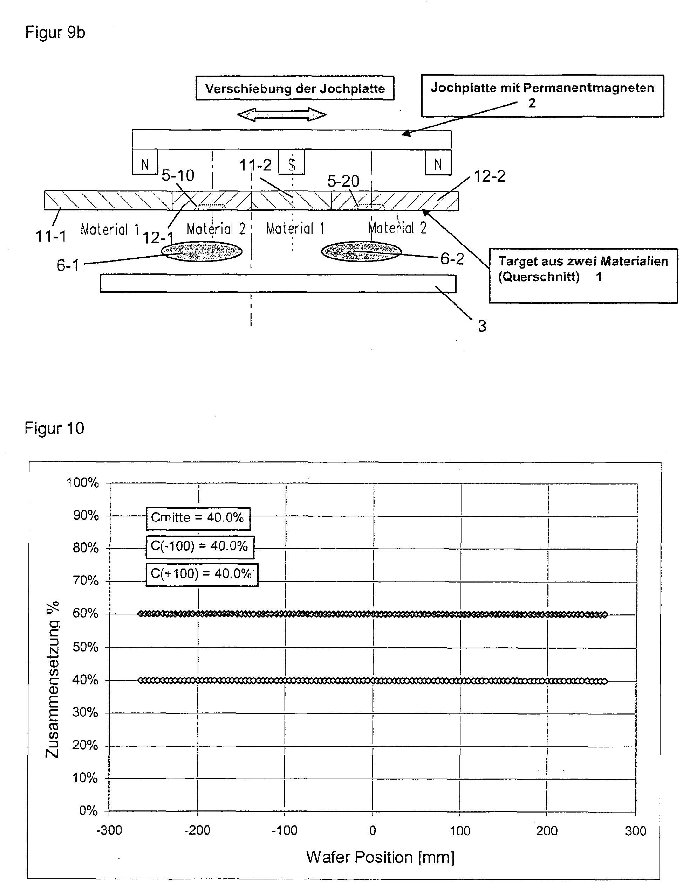

Gemäß einer weiteren Ausführungsform der Erfindung kann auch eine homogene Legierungsschicht über die gesamte Breite des Substrats erzeugt werden. Hierzu kann ein Target 1 verwendet werden, wie es in Fig. 9a gezeigt ist. Das Target gemäß Fig. 9a wird z.B. aus vier anstelle von drei Materialstücken zusammengesetzt, wobei je zwei Stücke 11-1 und 11-2 aus Material 1 und zwei Stücke 12-1 und 12-2 aus Material 2 hergestellt sind. Die jeweiligen Targetstücke sind rechteckig, so dass sich Materialgrenzen 4-1, 4-2 und 4-3 ergeben, die in Längsrichtung des Targets 1 und des Substrats 3 verlaufen. Die Vorrichtung gemäß Fig. 9b entspricht der in den Figuren 4 und 5 gezeigten Vorrichtung, jedoch wird im Falle der Fig. 9b das Target gemäß Fig. 9a verwendet. Durch eine Verschiebung der Jochplatte 2 kann der Anteil an Material 1 und Material 2 in der auf dem Substrat entstehenden Legierung eingestellt werden. Bei einer Einstellung, wie sie in Fig. 9b gezeigt ist, wird im Wesentlichen lediglich Material 2 vom Target abgelöst, so dass sich eine homogene Schicht aus diesem Material auf dem Substrat ergibt. Durch Verschieben der Magnetanordnung nach links, wie sie in Fig. 9b angedeutet ist, kann der Anteil an den Materialien 1 und 2 in der sich ergebenden Legierung gezielt und über einen großen Bereich gesteuert werden. Eine sich dadurch ergebende Konzentration in zwei verschiedenen Legierungszusammensetzungen ist in Fig. 10 gezeigt. Die Legierungszusammensetzung ist über die Positionen auf dem Substrat 3 konstant, der Anteil eines der die Legierung aufbauenden Materialien kann jedoch gezielt eingestellt werden.

Durch einen geeigneten Aufbau des Targets können auch andere Legierungszusammensetzungen bzw. gradienten erzeugt werden. So ist beispielsweise auch ein Einsatz von trapezförmigen Targetabschnitten bei einem vierteiligen Target möglich, um Legierungsgradienten abzuscheiden und einzustellen. Auch ist möglich, durch Verwendung von mehr als zwei Materialien Legierungen aus drei oder mehr Bestandteilen zu erzeugen.

Gemäß der Erfindung kann statt des Einsatzes von Permanentmagneten auf der Jochplatte auch die Verwendung von Elektromagneten vorgesehen werden.

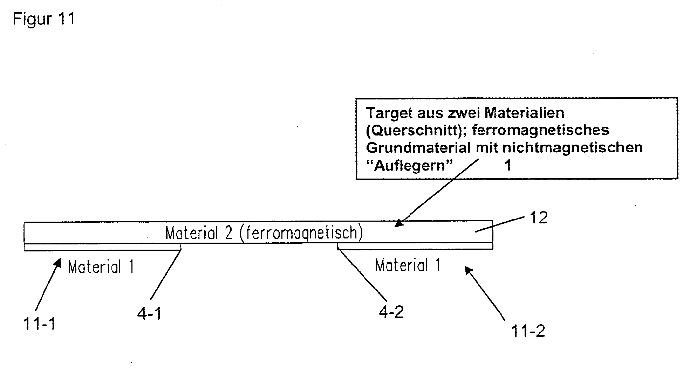

Gemäß einer weiteren Ausführungsform der Erfindung (Fig. 11) ist es auch möglich, das Target 1 aus einem einzigen Grundabschnitt 12 herzustellen und das erste Material 1 lediglich auf den gewünschten Abschnitten 11-1 und 11-2 der Oberfläche des Grundabschnitts 12 aufzubringen. Ein solcher Aufbau ist beispielhaft in Fig. 11 gezeigt; in diesem Beispiel besteht der Grundabschnitt 12 aus ferromagnetischem Material 2. Das Material 1 kann z.B. nicht-ferromagnetisch sein.

Bei der Herstellung einer Schicht auf einem Substrat mittels Kathodenzerstäubung kann mit der vorliegenden Erfindung also eine Legierung aufgetragen werden, die zumindest zwei Legierungsbestandteile aufweist. Bei Verwendung von trapezförmigen Targetstücken gemäß einer ersten Ausführungsform der Erfindung kann bezüglich der Position auf dem Substrat ein Gradient in der Legierungszusammensetzung erzeugt werden, wobei die Steilheit des Trapezes die Grundfunktion des Konzentrationsgradienten ergibt. Bei Verwendung von rechteckigen Targetstücken anstelle von trapezförmigen Targetstücken kann eine bestimmte homogene Konzentration über dem Substratdurchmesser erzeugt werden. Eine Bewegung des Erosionsabschnitts senkrecht zur Längsausdehnung des Targets, die durch eine Bewegung der Magnetanordnung in der Querrichtung des Targets erzeugt werden kann, ist eine Veränderung der Steilheit des Gradienten bei Verwendung trapezförmiger Targetstücke möglich. Bei rechteckigen Targetteilstücken kann durch eine solche Bewegung der Magnetanordnung eine Veränderung der homogenen Legierungszusammensetzung erreicht werden, wobei der Effekt besonders signifikant bei Verwendung von vier anstelle von drei Targetteilstücken ist. Durch Verkippen der Magnetanordnung um eine Achse parallel zur Längsrichtung des Targets kann die Abtragrate in den Erosionsgräben senkrecht zur Längsausdehnung des Targets verändert werden; dadurch kann die mittlere Rate oder auch die homogene Legierungszusammensetzung bei rechteckigen Target-Teilstücken verschoben werden. Durch derartiges Verkippen ist auch eine Kompensation unterschiedlicher spezifischer Sputter-Raten der Legierungsbestandteile möglich. Alternativ zur Ausbildung des Targets aus Targeteinzelstücken kann auch eines der verwendeten Materialien in den erwünschten Abschnitten auf einen Grundabschnitt des Targets aufgebracht werden. Dies ist insbesondere zweckmäßig bei Verwendung eines ferromagnetischen Grundabschnitts als eines der Materialien und eines weiteren nicht-ferromagnetischen Materials.

## Patentansprüche

1. Verfahren zum Beschichten eines Substrats (3), das eine Breite und eine Länge hat, mit einer Legierung aus mindestens einem ersten und einem zweiten Material als Legierungsbestandteile und mit variablem Legierungsverhältnis durch Magnetron-Kathodenzerstäubung, mit
(a) einer Magnetron-Zerstäubungskathode mit
(a1) einem die Legierungsbestandteile aufweisendem Target (1) und
(a2) einer von dem Substrat (3) aus gesehen hinter dem Target (1) angeordneten Magnetanordnung (2) zur Ausbildung mindestens eines Erosionsabschnitts (5) auf der Oberfläche des Targets (1),
wobei
(b) die Oberfläche des Targets (1) zumindest einen ersten Abschnitt (11) aus dem ersten Material und einen zweiten Abschnitt (12) aus dem zweiten Material aufweist,
(c) der erste Abschnitt (11) und der zweite Abschnitt (12) aneinander angrenzen und eine gemeinsame Grenzlinie (4) auf der Oberfläche des Targets (1) bilden, und
(d) der Erosionsabschnitt (5) im Bereich der Grenzlinie (4) positioniert ist, so dass ein erster Teil (5-1) des Erosionsabschnitts (5) auf dem ersten Targetabschnitt (11) und ein zweiter Teil (5-2) des Erosionsabschnitts (5) auf dem zweiten Targetabschnitt (12) liegt,
**gekennzeichnet durch**
(e) Verändern des Legierungsverhältnisses durch
(e1) Verschieben des Erosionsabschnitts (5) quer zur Grenzlinie (4),
und/oder
(e2) Einstellen eines spitzen Winkels α zwischen der Grenzlinie (4) und der Längsrichtung des Erosionsabschnitts in einer Ebene parallel zur Oberfläche des Targets (1),
und/oder
(e3) Einstellen eines Winkels β zwischen der Oberfläche der Magnetanordnung und der dem Substrat (3) zugewandten Oberfläche des Targets (1), und
(f) Ändern der Relativposition zwischen der Magnetron-Zerstäubungskathode und der Oberfläche des Substrats (3) durch lineares Bewegen des Substrates (3) parallel zur Oberfläche des Substrats.

2. Verfahren nach Anspruch 1, mit einer langgestreckten Magnetron-Zerstäubungskathode, die sich über die Breite des Substrats (2) erstreckt, durch Ausrichten der Magnetanordnung (2) mit ihrer Längsrichtung parallel oder in einem spitzen Winkel α zur Grenzlinie (4) in einer Ebene parallel zur Oberfläche des Targets (1).

3. Verfahren nach einem der Ansprüche 1 bis 2, durch Verkippen der Magnetanordnung (2) um eine Achse bezüglich der Targetoberfläche um einen Winkel β.

4. Vorrichtung zum Beschichten eines Substrats (3) mit einer Legierung aus mindestens einem ersten und einem zweiten Material als Legierungsbestandteile und mit variablem Legierungsverhältnis durch Magnetron-Kathodenzerstäubung, mit
(a) einer Magnetron-Zerstäubungskathode, mit
(a1) einem Target (1), und
(a2) einer von dem Substrat (3) aus gesehen hinter dem Target (1) angeordneten Magnetanordnung geeignet zur Ausbildung eines Erosionsabschnitts (5) auf der Oberfläche des Targets (1),
**dadurch gekennzeichnet, dass**
(b) die Oberfläche des Targets (1) zumindest einen ersten Abschnitt (11) aus einem ersten Material und einen zweiten Abschnitt aus einem zweiten Material aufweist, wobei der erste Abschnitt (11) und der zweite Abschnitt (12) aneinander angrenzen und eine gemeinsame Grenzlinie (4) auf der Oberfläche des Targets (1) bilden, und
(c) die Magnetanordnung (2)
(c1) in einer Richtung parallel zur Targetoberfläche und senkrecht zur Grenzlinie des Targets (1) oder die Längsrichtung des Erosionsabschnitts unter einem Winkel α gegenüber der Grenzlinie (4) verschiebbar ist,
und/oder
(c2) um eine Achse bezüglich der Targetoberfläche um einen Winkel β verkippbar ist oder die Targetoberfläche um eine Achse bezüglich der Magnetanordnung (2) um einen Winkel β verkippbar ist,
und/oder
(c3) im Fall einer langgestreckten Magnetron-Zerstäubungskathode, d.h. Langkathode, die sich über die Breite des Substrats erstreckt und einer langgestreckten Magnetanordnung, die eine Breite und eine Länge hat, durch Ausrichten der Länge der Magnetanordnung in einem Winkel α zur Grenzlinie auf der Targetoberfläche bezüglich der Grenzlinie (4) unter einem Winkel α einstellbar ist, und
(d) die Vorrichtung dafür konfiguriert ist, die Relativposition zwischen der Magnetron-Zerstäubungskathode und der Oberfläche des Substrats (3) durch lineares Bewegen des Substrates (3) parallel zur Oberfläche des Substrats zu ändern.

5. Vorrichtung nach Anspruch 4, wobei die Magnetron-Zerstäubungskathode als Langkathode ausgebildet ist.

6. Vorrichtung nach Anspruch 4 oder 5, wobei die Magnetanordnung (2) Permanentmagnete oder Elektromagnete aufweist.

7. Verwendung eines Targets in einem Verfahren zum Beschichten eines Substrats (3) nach einem der Ansprüche 1 bis 3 oder in einer Vorrichtung zum Beschichten eines Substrats (3) nach einem der Ansprüche 4 bis 6, wobei die Oberfläche des Targets (1) zumindest einen ersten Abschnitt aus einem ersten Material und einen zweiten Abschnitt (12) aus einem zweiten Material aufweist, wobei der erste Abschnitt (11) und der zweite Abschnitt (12) aneinander angrenzen und eine gemeinsame Grenzlinie (4) auf der Oberfläche des Targets (1) bilden, wobei der Erosionsabschnitt (5) parallel oder in einem spitzen Winkel α zur Grenzlinie (4) liegt, wobei die Oberfläche des Targets (1) rechteckig ist, wobei die Abschnitte (11, 12) der Oberfläche des Targets (1) trapezförmig angeordnet sind, um auf der Oberfläche des Targets (1) Streifen unterschiedlicher Materialien zu bilden, deren Grenzlinie (4) gegenüber der Längsseite des Targets um einen Winkel geneigt ist.

8. Verwendung nach Anspruch 7, wobei die Oberfläche des Targets (1) drei Abschnitte (11, 12) aufweist, wobei ein Abschnitt (11) aus dem ersten Material und zwei an den ersten Abschnitt (11) angrenzende Abschnitte (12-1) und (12-2) aus dem zweiten Material gebildet sind und deren Grenzlinien (4-1, 4-2) gegenüber der Längsseite des Targets um einen Winkel geneigt sind.

9. Verwendung nach Anspruch 7, wobei die Oberfläche des Targets (1) vier Abschnitte (11, 12) aufweist, wobei zwei der Abschnitte (11) aus dem ersten Material und die anderen beiden Abschnitte (12) aus dem zweiten Material gebildet sind und die Abschnitte aus den unterschiedlichen Materialien alternierend angeordnet sind.

10. Verwendung nach einem der Ansprüche 7 bis 9, wobei das Target (1) aus mehreren Einzelstücken zusammengesetzt ist, deren Oberflächen die Abschnitte der Oberfläche des Targets bilden, und wobei zumindest eines der Einzelstücke aus dem ersten Material und zumindest ein weiteres der Einzelstücke aus dem zweiten Material besteht.

11. Verwendung nach einem der Ansprüche 7 bis 10, wobei die verschiedenen Abschnitte zumindest an der Oberfläche das Targets (1) gebildet sind, indem das Target (1) aus dem ersten Material hergestellt ist und eine Schicht aus dem zweiten Material aufgebracht ist, wobei bevorzugt das erste Material ferromagnetisch und das zweite Material nicht-ferromagnetisch ist.

12. Verwendung nach einem der Ansprüche 7 bis 11, wobei die Abschnitte (11) aus dem ersten Material und die angrenzenden Abschnitte (12) aus dem zweiten Material jeweils eine Trapezform haben.

## Claims

1. A method for coating a substrate (3), which has a width and a length, with an alloy comprising at least a first and a second material as alloy components and having a variable alloy ratio by means of magnetron cathode sputtering, comprising
(a) a magnetron sputtering cathode with
(a1) a target (1) comprising the alloy components and
(a2) a magnet arrangement (2) which is arranged behind the target (1) when viewed from the substrate (3) for forming at least one erosion section (5) on the surface of the target (1),
wherein
(b) the surface of the target (1) comprises at least a first section (11) of the first material and a second section (12) of the second material,
(c) the first section (11) and the second section (12) adjoin each other and form a common boundary line (4) on the surface of the target (1), and
(d) the erosion section (5) is positioned in the area of the boundary line (4) so that a first part (5-1) of the erosion section (5) lies on the first target section (11) and a second part (5-2) of the erosion section (5) lies on the second target section (12),
**characterized by**
(e) changing the alloy ratio by
(e1) moving the erosion section (5) transversely with respect to the boundary line (4),
and/or
(e2) adjusting an acute angle α between the boundary line (4) and the longitudinal direction of the erosion section in a plane parallel to the surface of the target (1),
and/or
(e3) adjusting an angle β between the surface of the magnet arrangement and the surface of the target (1) facing the substrate (3), and
(f) changing the relative position between the magnetron sputtering cathode and the surface of the substrate (3) by linearly moving the substrate (3) parallel with respect to the surface of the substrate.

2. The method according to claim 1, comprising an elongate magnetron sputtering cathode extending across the width of the substrate (2), by aligning the magnet arrangement (2) with its longitudinal direction parallel or at an acute angle α with respect to the boundary line (4) in a plane parallel to the surface of the target (1).

3. The method according to any one of claims 1 to 2, by tilting the magnet arrangement (2) about an axis relative to the target surface by an angle β.

4. A device for coating a substrate (3) with an alloy comprising at least a first material and a second material as alloy components and having a variable alloy ratio by means of magnetron cathode sputtering, comprising
(a) a magnetron sputtering cathode comprising
(a1) a target (1), and
(a2) a magnet arrangement which is arranged behind the target (1) when viewed from the substrate (3) for forming an erosion section (5) on the surface of the target (1),
**characterized in that**
(b) the surface of the target (1) comprises at least a first section (11) of a first material and a second section of a second material, wherein the first section (11) and the second section (12) adjoin each other and form a common boundary line (4) on the surface of the target (1), and
(c) the magnet arrangement (2)
(c1) is movable in a direction parallel to the target surface and perpendicular to the boundary line of the target (1) or the longitudinal direction of the erosion section is movable at an angle α relative to the boundary line (4),
and/or
(c2) is tiltable about an axis relative to the target surface by an angle β or the target surface is tiltable about an axis relative to the magnet arrangement (2) by an angle β,
and/or
(c3) when using an elongate magnetron sputtering cathode, i.e., a long cathode, extending across the width of the substrate and an elongate magnet arrangement having a width and a length, is adjustable relative to the boundary line (4) at an angle α by aligning the length of the magnet arrangement at an angle α with respect to the boundary line on the target surface, and
(d) the device is configured to change the relative position between the magnetron sputtering cathode and the surface of the substrate (3) by linear movement of the substrate (3) parallel with respect to the surface of the substrate.

5. The device according to claim 4, wherein the magnetron sputtering cathode is formed as a long cathode.

6. The device according to claim 4 or 5, wherein the magnet arrangement (2) comprises permanent magnets or electromagnets.

7. Use of a target in a method for coating a substrate (3) according to any one of claims 1 to 3, or in a device for coating a substrate (3) according to any one of claims 4 to 6, wherein the surface of the target (1) comprises at least a first section of a first material and a second section (12) of a second material, wherein the first section (11) and the second section (12) adjoin each other and form a common boundary line (4) on the surface of the target (1), wherein the erosion section (5) lies parallel or at an acute angle α relative to the boundary line (4), wherein the surface of the target (1) is rectangular, wherein the sections (11, 12) of the surface of the target (1) are arranged in a trapezoidal shape in order to form on the surface of the target (1) strips of different materials whose boundary lines (4) are inclined by an angle with respect to the longitudinal side of the target.

8. The use according to claim 7, wherein the surface of the target (1) comprises three sections (11, 12), wherein one section (11) is made of the first material and two sections (12-1 and 12-2) adjoining the first section (11) are made of the second material and their boundary lines (4-1, 4-2) are inclined by an angle with respect to the longitudinal side of the target.

9. The use according to claim 7, wherein the surface of the target (1) comprises four sections (11, 12), wherein two of the sections (11) are made of the first material and the other two sections (12) are made of the second material and the sections of the different materials are arranged alternatingly.

10. The use according to any one of claims 7 to 9, wherein the target (1) is composed of a plurality of individual pieces, the surfaces of which form the sections of the surface of the target, and wherein at least one of the individual pieces is made of the first material and at least a further one of the individual pieces is made of the second material.

11. The use according to any one of claims 7 to 10, wherein the different sections are at least formed on the surface of the target (1) with the target (1) being formed of the first material and a layer of the second material being applied, wherein preferably the first material is ferromagnetic and the second material is non-ferromagnetic.

12. The use according to any one of claims 7 to 11, wherein the sections (11) of the first material and the adjoining sections (12) of the second material each have a trapezoidal shape.

## Revendications

1. Procédé de revêtement d'un substrat (3), qui a une largeur et une longueur, avec un alliage composé d'au moins un premier et un deuxième matériau comme composants d'alliage et avec un rapport d'alliage variable, par pulvérisation cathodique magnétron, avec
(a) une cathode de pulvérisation magnétron comportant
(a1) une cible (1) présentant les composants d'alliage et
(a2) un dispositif magnétique (2) disposé derrière la cible (1) en vue depuis le substrat (3) pour la formation d'au moins un tronçon d'érosion (5) sur la surface de la cible (1),
dans lequel
(b) la surface de la cible (1) présente au moins un premier tronçon (11) composé du premier matériau et un deuxième tronçon (12) composé du deuxième matériau,
(c) le premier tronçon (11) et le deuxième tronçon (12) sont adjacents et forment une ligne de délimitation (4) commune sur la surface de la cible (1), et
(d) le tronçon d'érosion (5) est placé dans la zone de la ligne de délimitation (4) de sorte qu'une première partie (5-1) du tronçon d'érosion (5) réside sur le premier tronçon cible (11) et une deuxième partie (5-2) du tronçon d'érosion (5) réside sur le deuxième tronçon cible (12), **caractérisé par**
(e) la modification du rapport d'alliage par
(e1) décalage du tronçon d'érosion (5) transversalement par rapport à la ligne de délimitation (4),
et/ou
(e2) ajustement d'un angle aigu α entre la ligne de délimitation (4) et la direction longitudinale du tronçon d'érosion (5) dans un plan parallèle à la surface de la cible (1),
et/ou
(e3) ajustement d'un angle β entre la surface du dispositif magnétique et la surface de la cible (1) tournée vers le substrat (3), et
(f) modification de la position relative entre la cathode de pulvérisation magnétron et la surface du substrat (3) par déplacement linéaire du substrat (3) parallèlement à la surface du substrat.

2. Procédé selon la revendication 1, avec une cathode de pulvérisation magnétron allongée, qui s'étend sur la largeur du substrat (2), par orientation du dispositif magnétique (2) avec sa direction longitudinale parallèle ou à un angle aigu α par rapport à la ligne de délimitation (4) dans un plan parallèle à la surface de la cible (1).

3. Procédé selon l'une des revendications 1 à 2, par basculement du dispositif magnétique (2) autour d'un axe par rapport à la surface cible à un angle β.

4. Dispositif pour le revêtement d'un substrat (3) avec un alliage composé d'au moins un premier et un deuxième matériau comme composants d'alliage et avec un rapport d'alliage variable, par pulvérisation cathodique magnétron, avec
(a) une cathode de pulvérisation magnétron comportant
(a1) une cible (1), et
(a2) un dispositif magnétique disposé derrière la cible (1) en vue depuis le substrat (3) approprié pour la formation d'au moins un tronçon d'érosion (5) sur la surface de la cible (1),
**caractérisé en ce que**
(b) la surface de la cible (1) présente au moins un premier tronçon (11) composé d'un premier matériau et un deuxième tronçon composé d'un deuxième matériau, où le premier tronçon (11) et le deuxième tronçon (12) sont adjacents et forment une ligne de délimitation (4) commune sur la surface de la cible (1), et
(c) le dispositif magnétique (2)
(c1) peut être décalé dans une direction parallèle à la surface de la cible et perpendiculaire à la ligne de délimitation de la cible (1) ou la direction longitudinale du tronçon d'érosion peut être décalée à un angle α par rapport à la ligne de délimitation (4),
et/ou
(c2) peut être basculé à un angle β autour d'un axe par rapport à la surface cible ou la surface cible peut être basculée à un angle β autour d'un axe par rapport au dispositif magnétique (2),
et/ou
(c3) dans le cas d'une cathode de pulvérisation magnétron allongée, c'est-à-dire d'une cathode longue, qui s'étend sur la largeur du substrat et d'un dispositif magnétique allongé, qui a une largeur et une longueur, est réglable sur un angle α par rapport à la ligne de délimitation par orientation de la longueur du dispositif magnétique à un angle α par rapport à la ligne de délimitation (4), sur la surface cible, et
(d) le dispositif est configuré, pour modifier la position relative entre la cathode de pulvérisation magnétron et la surface du substrat (3) par déplacement linéaire du substrat (3) parallèlement à la surface du substrat.

5. Dispositif selon la revendication 4, où la cathode de pulvérisation magnétron est configurée sous forme de cathode longue.

6. Dispositif selon la revendication 4 ou 5, où le dispositif magnétique (2) présente des aimants permanents ou des électro-aimants.

7. Utilisation d'une cible dans un procédé pour le revêtement d'un substrat (3) selon l'une des revendications 1 à 3 ou dans un dispositif pour le revêtement d'un substrat (3) selon l'une des revendications 4 à 6, où la surface de la cible (1) présente au moins un premier tronçon composé d'un premier matériau et un deuxième tronçon (12) composé d'un deuxième matériau, où le premier tronçon (11) et le deuxième tronçon (12) sont adjacents et forment une ligne de délimitation (4) commune sur la surface de la cible (1), où le tronçon d'érosion (5) est parallèle ou à un angle aigu α par rapport à la ligne de délimitation (4), où la surface de la cible (1) est rectangulaire, où les tronçons (11, 12) de la surface de la cible (1) sont disposés en une forme trapézoïdale pour former, sur la surface de la cible (1), des bandes de différents matériaux dont la ligne de délimitation (4) est inclinée à un angle à l'opposé du côté longitudinal de la cible.

8. Utilisation selon la revendication 7, où la surface de la cible (1) présente trois tronçons (11, 12), où un tronçon (11) est formé à partir du premier matériau et deux tronçons (12-1) et (12-2) adjacents au premier tronçon (11) sont formés à partir du deuxième matériau et leurs lignes de délimitation (4-1, 4-2) sont inclinées à un angle à l'opposé du côté longitudinal de la cible.

9. Utilisation selon la revendication 7, où la surface de la cible (1) présente quatre tronçons (11, 12), où deux des tronçons (11) sont formés à partir du premier matériau et les deux autres tronçons (12) sont formés à partir du deuxième matériau et les tronçons composés de différents matériaux sont disposés en alternance.

10. Utilisation selon l'une des revendications 7 à 9, où la cible (1) est composée de plusieurs éléments, dont les surfaces forment les tronçons de la surface de la cible, et où au moins l'un des éléments se compose du premier matériau et au moins un autre des éléments se compose du deuxième matériau.

11. Utilisation selon l'une des revendications 7 à 10, où les divers tronçons sont formés au moins sur la surface de la cible (1), en fabriquant la cible (1) à partir du premier matériau et une couche à partir du deuxième matériau est déposée, où, de préférence, le premier matériau est ferromagnétique et le deuxième matériau n'est pas ferromagnétique.

12. Utilisation selon l'une des revendications 7 à 11, où les tronçons (11) composé du premier matériau et les tronçons (12) adjacents composés du deuxième matériau ont respectivement une forme trapézoïdale.
